# EUROPÄISCHE PATENTSCHRIFT

(11) **EP 3 714 514 B1**
(45) Veröffentlichungstag und Bekanntmachung des Hinweises auf die Patenterteilung: **07.12.2022**
(21) Anmeldenummer: 18800843.7
(22) Anmeldetag: 12.10.2018
(51) Int. Cl.: H01R 12/72, H01R 13/436, H01R 13/04, H05K 3/30, H01R 12/57

(54) **STECKVERBINDER**
PLUG-TYPE CONNECTOR
CONNECTEUR ENFICHABLE

(30) Priorität: 21.11.2017 DE 102017127482
(43) Veröffentlichungstag der Anmeldung: 30.09.2020
(73) Patentinhaber: Phoenix Contact GmbH & Co KG, 32825 Blomberg (DE)
(72) Erfinder: HIEBER, Alexander, 71083 Herrenberg (DE); DELKER, Michael, 71083 Herrenberg (DE)
(86) Internationale Anmeldenummer: PCT/DE2018/100839
(87) Internationale Veröffentlichungsnummer: WO 2019/101262

(56) Entgegenhaltungen:
- EP-A2- 1 517 409
- DE-A1- 19 618 497
- DE-T2- 69 309 761
- JP-A- 2003 257 518
- US-A1- 2011 143 564

## Beschreibung

Die Erfindung betrifft einen Steckverbinder zur Herstellung einer externen Verbindung mit einer Leiterplatte, der zumindest zwei gewinkelte stiftförmige Kontakte mit einem ersten Schenkel zur Kontaktierung eines Gegensteckverbinders und einem zweiten Schenkel zur Kontaktierung der Leiterplatte, einen Isolierkörper zur Aufnahme der Kontakte zumindest im Bereich des ersten Schenkels und einen Kontaktträger zur Aufnahme der Kontakte an ihrem zweiten Schenkel aufweist, wobei die Kontakte in einem Bereich am Ende des zweiten Schenkels einen in axialer Richtung des zweiten Schenkels wirkenden Anschlag aufweisen, der Kontaktträger in dem Bereich des zweiten Schenkels angeordnet ist und für die zweiten Schenkel Durchgangsöffnungen mit einem Gegenanschlag aufweist und in axialer Richtung der zweiten Schenkel in ein den Kontaktträger aufnehmendes Gehäuse des Steckverbinders bewegbar und darin fixierbar ist.

Bei derart ausgestalteten Steckerbindern sind im Wesentlichen bei auf dem Markt erhältlichen Steckverbindern zwei Varianten verbreitet. Bei der ersten Variante sind die gewinkelten Kontakte mittels Formschuss oder Presspassung in einem Isolierkörper fixiert. Ein weiteres Bauteil führt die zu der Oberfläche der Leiterplatte hin orientierten Schenkel der gewinkelten Kontakte radial. Dadurch können Toleranzen im Fertigungsprozess kompensiert werden und die radiale Führung bietet zusätzlichen Schutz gegen ein Verdrehen der Kontakte bei der Montage auf eine Leiterplatte, die typischerweise per Hand erfolgt. Die zweite Variante kommt ohne das zusätzliche Bauteil zur Führung aus und setzt stattdessen auf einen besseren Formschluss zwischen dem Isolierkörper und den Kontakten, um den Widerstand gegen eine Verdrehung der Kontakte, insbesondere bei der Montage wirkungsvoll zu erhöhen.

Beide Varianten berücksichtigen jedoch lediglich die radiale Positionierung der Kontakte relativ zu der Oberfläche einer Leiterplatte, aber nicht die steigenden Anforderungen an die axiale Positionierung der Kontakte relativ zu der Oberfläche einer Leiterpleite bedingt durch neue Verfahren zur Befestigung der Steckverbinder an Leiterplatten. Bei der Befestigung der Steckverbinder mittels einer Kombination von Wellenlöten und THR-Verfahren (Through-Hole-Reflow) oder als SMD-Bauteil (Surface-Mount-Device) spielen mehrere Toleranzen zusammen, wie die Fertigungstoleranz des Kontaktes, des Isolierkörpers und ggf. weiterer Bauteile. Neben der radialen Führung der Kontakte ist somit auch die axiale Genauigkeit von Bedeutung.

In der DE 197 54 877 A1 wird ein zur Montage auf einer Leiterplattenoberfläche ausgelegtes Bauteil mit einer Vielzahl von Anschlussbeinen beschrieben. Das Bauteil zeichnet sich dadurch aus, dass die Anschlussbeine zumindest teilweise durch ein von diesen durchlaufendes Justierelement in einer vorbestimmten Relativlage fixiert sind. Dadurch kann erreicht werden, dass das Bauteil stets ordnungsgemäß auf die Leiterplattenoberfläche montierbar ist. Das plattenartige Justierelement wird von den freien Endabschnitten der Anschlussbeine her über diese aufgeschoben, wobei die Aussparungen des Justierelements, durch welche die Anschlussbeine verlaufen, und die Anschlussbeine selbst so ausgebildet sind, dass diese in einer bestimmungsgemäßen Endlage des Justierelements aneinander verklemmt sind. Die vorbestimmte Relativlage in welche die Anschlussbeine durch das Justierelement gebracht werden sollen, besteht unter anderem darin, dass die mit der Leiterplatte zu verlötenden Abschnitte der Anschlussbeine in einer Eben zu liegen kommen. Das Justierelement wird vorzugsweise zuletzt auf das ansonsten fertig herstellte Bauteil aufgesetzt. Die Anschlussbeine sind derart ausgebildet, dass das Aufschieben des Justierelement zunächst im Wesentlichen widerstandslos vonstattengeht, mit fortschreitendem Aufschieben, aber mit einer zunehmenden gegenseitigen Verklemmung einhergeht. Bei Erreichen der bestimmungsgemäßen Endlage des Justierelements sind das Justierelement und die Anschlussbeine so fest miteinander verbunden, dass keine Relativbewegung mehr möglich ist und die Anschlussbeine in ihrer Relativlage fixiert sind. Die darin beschriebene Ausrichtung der Anschlussbeine ist aufgrund der geforderten Ausgestaltung des eingangs beschriebenen Steckverbinders für eine radiale Führung nicht geeignet.

Die DE 196 184 97 A1 offenbart ein rechtwinkliges elektrisches Verbindergehäuse mit einer Vielzahl von Kontakten und weist eine Verbindungsendfläche sowie eine dazu rechtwinklig angeordnete Montageendfläche auf. Die Kontakte werden im Verbindungsbereich mittels Pressverbindung an einer durchplattierten Bohrung in einer Unterlage verbunden. Zwischen der Verbindungsendfläche und der Montageendfläche weist das Verbindergehäuse eine Druckhaube auf. Auf zwei einander gegenüberliegenden Seitenwänden der Druckhaube ist ein Stützelement mit einem Fuß angeordnet. Das Stützelement weist eine schwalbenschwanzförmige Feder auf, die zu einer komplementären Nut am Verbindergehäuse parallel zur Montageendfläche einschiebbar ist. Die Einpresskräfte, die bei der Pressverbindung der Kontakte an der Unterlage überwunden werden müssen, werden von der Druckhaube auf das Verbindergehäuse übertragen.

In der DE 693 09 761 T2 wird ein elektrischer Verbinder zur Montage auf einer Leiterplatte mit einem Gehäuse, mit einem Paar beabstandeter, rudimentärer Bodenwände, die jeweils eine Bodenfläche zum Eingriff gegen die Leiterplatte aufweisen, beschrieben. Jede Bodenwand weist eine darin ausgebildete Durchgangsbohrung auf, die in die Bodenfläche mündet und sich ebenfalls nach oben öffnet. Ein in jeder der Bohrungen abgestütztes Hohlkastenschloss weist Verriegelungsbeine auf, die unter die Unterseite der jeweiligen Bodenwand ragen und in ein Loch in einer Leiterplatte eingesetzt werden können. Das Gehäuse weist einen Kopf auf, der elektrische Anschlüsse mit Anschlussbeinen trägt, die nach hinten aus dem Kopf ragen und in Lötfahnen enden. Eine die Anschlussbeine abdeckende Metallabschirmung weist Erdungslaschen auf, die sich durch entsprechende Platinenschlösser erstrecken und gleichzeitig mit den Verriegelungsbeinen mit den Erdungsleitern verlötet sind.

Im Rahmen der JP 2003 257518 A wird ein elektrischer Verbinder offenbart, der mit Kontakten versehen ist, bestehend aus Kontaktteilen in Kontakt mit Gegenstückkontakten, einem festen Teil, der an einem Block befestigt ist, und einem Verbindungsteil, der mit einer Leiterplatte verbunden ist. An dem Block sind dabei eine Anzahl von Kontakten gehalten und fixiert. Des Weiteren weist der elektrische Verbinder einen Positionierer zur Positionierung der Kontakte auf der Leiterplatte auf. Die Kontakte weisen an Ihrem verbindungsseitigen Abschnitt Anformungen mit Schrägflächen auf. Der Positionierer weist entsprechende Ausnehmungen im Bereich der Kontakteinsetzöffnung auf zum Einsetzen und Durchführen der verbindungsseitigen Abschnitte der Kontakte und deren Positionierung auf der Leiterplatte auf.

DE 196 18 497 A1, DE 693 09 761 T2 und JP 2003 257518 A offenbaren jeweils den Oberbegriff von Anspruch 1.

Der vorliegenden Erfindung liegt daher die Aufgabe zugrunde, eine Möglichkeit für den eingangs genannten Steckverbinder vorzuschlagen um die Kontakte bei radialer Führung auch axial auszurichten und die axiale Genauigkeit zu verbessern. Weiter soll die Ausbildung eines standfesten Steckverbinders vor dem Löten auch möglich sein.

Diese Aufgabe wird erfindungsgemäß durch die Merkmale des Anspruchs 1 gelöst. Weitere vorteilhafte Ausgestaltungen sind den jeweils rückbezogenen Unteransprüchen zu entnehmen.

Gemäß der Erfindung wird der Anschlag zumindest an dem zweiten Schenkel und der Gegenanschlag in den Durchgangsöffnungen durch einen Absatz in Form eines Ringbundes beim Übergang von einem größeren Durchmesser auf einen kleineren Durchmesser bei den Kontakten und Durchgangsöffnungen gebildet. Der Kontaktträger mit dem Gegenanschlag ist dabei so ausgebildet, dass aus dem Kontaktträger noch das Ende des Kontaktes herausragt, um dieses mit der Leiterplatte verbinden zu können. Das den Kontaktträger aufnehmende Gehäuse kann je nach Ausgestaltung des Steckverbinders durch eine das Gehäuse bildende Anformung an den Isolierkörper oder als getrenntes Gehäuseteil realisiert sein, wobei der Kontaktträger in axialer Richtung über die freien Enden der Kontakte in das Gehäuse bewegt und in diesem in axialer Richtung der Kontakte aber auch in radialer Richtung der Kontakte fixierbar ist. Bei der Ausbildung des Gehäuses als Anformung derart, dass der Isolierkörper gleichzeitig das Gehäuse für den Kontaktträger bildet, sind eine Schirmung und eine Standfestigkeit des Steckverbinders auf der Leiterplatte vordem Löten aufwändiger zu realisieren als bei der Ausbildung als getrenntes Bauteil.

Durch diese Ausgestaltung liegen die Kontakte definiert an dem Kontaktträger an. Der als Anschlag dienende Ringbund am Kontakt und der als Gegenanschlag dienende Absatz am Kontaktträger werden genutzt, um mit einer gewissen Kraft den Kontakt in das Gehäuse zu drücken. Dadurch werden möglicherweise die gewinkelten Kontakte nach oben gebogen, wobei dies in einem Umfang erfolgt, der die gesamte Fertigungstoleranz der einzelnen Kontakte in ihrer Längentoleranz abdeckt. Die damit ungenaue Fertigungstoleranz von üblicherweise +- 0,1 mm wird auf die Genauigkeit der Auflagefläche des Kontaktträgers reduziert.

Gemäß einer bevorzugten Ausbildung der Erfindung liegen die Ringbunde in den Durchgangsöffnungen in einer Ebene. Damit ist es möglich, alle Kontakte auf einer Ebene mit einer Toleranz von < 0,1 mm anzuordnen, sodass auch die SMD-Technologie für diesen Steckverbinder angewandt werden kann. Zusätzlich kann der Prüfaufwand reduziert werden, da nicht mehr jeder Kontakt auf seine Position geprüft werden muss.

Zum besseren Einführen der Kontakte in die Durchgangsöffnungen sind diese gemäß einer bevorzugten Ausbildung auf der dem ersten Schenkel zugewandten Seite des Kontaktträgers konisch ausgebildet.

Wie vorstehend ausgeführt, kann das Gehäuse auch durch eine entsprechende Ausgestaltung einer an dem üblicherweise länglich ausgebildeten Isolierkörper zur Aufnahme der ersten Schenkel ausgebildeten Anformung realisiert sein. Gemäß einer weiteren Ausbildung übergreift das Gehäuse den Isolierkörper mit dem darin angeordneten Kontakten in einem hinteren Isolierkörperteil zumindest teilweise und den Kontaktträger vollständig. Der üblicherweise länglich ausgebildete Isolierkörper mit einem vorderen Isolierkörperteil für die ersten Schenkel der Kontakte und zur Kontaktierung mit einem Gegensteckverbinder wird bei dieser bevorzugten Ausgestaltung an seinem dem zweiten Schenkel zugewandten Ende (dem hinteren Isolierkörperteil) teilweise von dem Gehäuse übergriffen, sodass dieses das Ende des ersten Schenkels und den zweiten Schenkel zusammen mit dem Kontaktträger vollständig überdeckt. Damit kann das Gehäuse auch metallisch ausgebildet sein, um zum einen in diesem Bereich aufgrund des Gewichts den Schwerpunkt des Steckverbinders zu realisieren, sodass dieser selbststehend für den Lötvorgang auf der Leiterplatte platziert werden kann. Zusätzlich bietet dies die Möglichkeit, bei einer metallischen Ausbildung des Gehäuses dieses als Schirmgehäuse auszubilden.

Die Fixierung des Kontaktträgers in dem Gehäuse erfolgt bevorzugt mittels einer Verrastung. Hierzu sind der Kontaktträger und das Gehäuse entsprechend aufeinander abgestimmt, beispielsweise durch geeignete Vorsprünge oder Öffnungen in dem Gehäuse und zugeordnete Schnapphaken am Kontaktträger oder umgekehrt. Der Isolierkörper weist vorteilhafter Weise mindestens einen Ausrichtfortsatz zum Einstecken in eine Bohrung auf der Leiterplatte und Ausrichtmittel zur horizontalen Ausrichtung des Gehäuses auf, damit darüber der Steckverbinder auf der Leiterplatte genau an seiner Position platziert werden kann. Das Gehäuse selbst kann lötbar ausgeführt sein, um eine zusätzliche Verbindung zwischen dem Steckverbinder und der Leiterplatte herzustellen.

Zweckmäßigerweise ist das Gehäuse U-förmig mit einem zwei Seitenwänden verbindenden Deckel ausgebildet, sodass es einfach den Kontaktträger teilweise und den Isolierkörper vollständig übergreifend mit diesem gemeinsam auf der Leiterplatte angeordnet werden kann.

Um dem Gehäuse eine Schirmfunktion zu geben, ist es metallisch und möglichst alle Seiten abdeckend auszubilden. Zweckmäßigerweise ist das Gehäuse dazu U-förmig mit einem zwei Seitenwände verbindenden Deckel ausgebildet, und besonders bevorzugt als Schirmblech mit einer Rückwand und einer gegenüberliegenden Stirnwand ausgebildet, wobei die Stirnwand das vordere Isolierkörperteil des Isolierkörpers über und seitlich umgreift. Je nach Fertigung kann die Stirnwand fest mit Gehäuse verbunden sein oder auch durch an den Isolierkörper anbringbare Teile der Stirnwand, die in elektrischem Kontakt mit Gehäuse stehen, realisiert sein. Letzteres kann insbesondere dann erforderlich sein, wenn die Stirnwand Kontaktfedern aufweist oder aus diesen gebildet wird, an die der Gegensteckverbinder zur Fixierung mit dem Steckverbinder und Sicherstellung einer ausreichenden Kontaktierung der Schirmung des Gegensteckverbinders mit dem Gehäuse anstößt.

Vorzugsweise kann das Gehäuse metallisch und gewichtsmäßig so ausgeführt sein, dass der Schwerpunkt eine stabile Lage des gesamten Steckverbinders vor dem Löten sicherstellt. Damit kann bei einem ausreichenden Gewicht des Gehäuses zusätzlich zur Einhaltung der Fertigungstoleranz während des Lötprozesses, insbesondere des SMD-Lötprozesses, das Gehäuse dazu verwendet werden, einen geraden Stand des Steckverbinders auf der Leiterplatte sicherzustellen. Das Gehäuse hält den Steckverbinder in der Waage, sodass die Kontakte mit den ersten Schenkeln horizontal in einer Ebene stehen. Der Schwerpunkt wird so verschoben, dass ein Abkippen des Steckverbinders während des Lötprozesses vermieden wird. Weiter ist das Gehäuse als metallisches Schirmgehäuse lötbar ausgeführt, um eine zusätzliche Verbindung zwischen Stecker und Leiterplatte herzustellen sowie die Schirmübertragung und die Erhöhung der Festigkeit sicherzustellen. Grundsätzlich kann der Steckverbinder auch mittels anderen Lötverfahren z. B. THR-Verfahren, auf der Leiterplatte angebracht werden.

Zusammenfassend ist festzustellen, dass mit dem vorstehend beschriebenen Steckverbinder einerseits in axialer Richtung eine Fertigungstoleranz von < 0,1 mm realisiert werden kann, wobei die Kontakte mit ihren der Leiterplatte zugewandten Enden möglichst auf einer Ebene liegen, und darüber hinaus einer Schirmung bei gleichzeitiger optimaler Standfestigkeit des Steckverbinders erreicht werden.

Die vorstehend in der Beschreibung genannten Merkmale und Merkmalskombinationen sowie nachfolgend in der Figurenbeschreibung genannten und/oder in den Figuren allein gezeigten Merkmale und Merkmalskombinationen sind nicht nur in der jeweils angegebenen Kombination, sondern auch in anderen Kombinationen oder in Alleinstellung verwendbar. Zur Ausführung der Erfindung müssen nicht alle Merkmale des Anspruchs 1 verwirklicht sein. Auch können einzelne Merkmale der unabhängigen oder nebengeordneten Ansprüche durch andere offenbarte Merkmale oder Merkmalskombinationen ersetzt werden.

Sämtliche aus den Ansprüchen, der Beschreibung oder der Zeichnung hervorgehenden Merkmale und/oder Vorteile, einschließlich konstruktive Einzelheiten, räumliche Anordnung und Verfahrensschritte können sowohl für sich als auch in den verschiedensten Kombinationen erfindungswesentlich sein. In den Figuren werden gleiche oder ähnliche Bauteile mit gleichen oder ähnlichen Bezugszeichen gekennzeichnet. Es stellen dar:
- Figur 1: die einzelnen Bauteile eines erfindungsgemäßen Steckverbinders vor dem Zusammenbau in einer perspektivischen Explosivdarstellung;
- Figur 2: eine Darstellung entsprechend Figur 1 von der Rückseite mit teilweisem Querschnitt durch den Steckverbinder und eingesteckten Kontakten;
- Figur 3: eine Ansticht ähnlich Figur 2 mit einem aufgesetzten Gehäuse und einen ausgerichteten jedoch nicht eingefügten Kontaktträger;
- Figur 4: ein Längsschnitt durch den Steckverbinder im fertig montiertem Zustand;
- Figur 5: einen Querschnitt durch den Steckverbinder entsprechend den Figuren 2 und 3 auf einer Leiterplatte; und
- Figur 6: eine perspektivische Ansicht des Steckverbinders auf einer Leiterplatte.

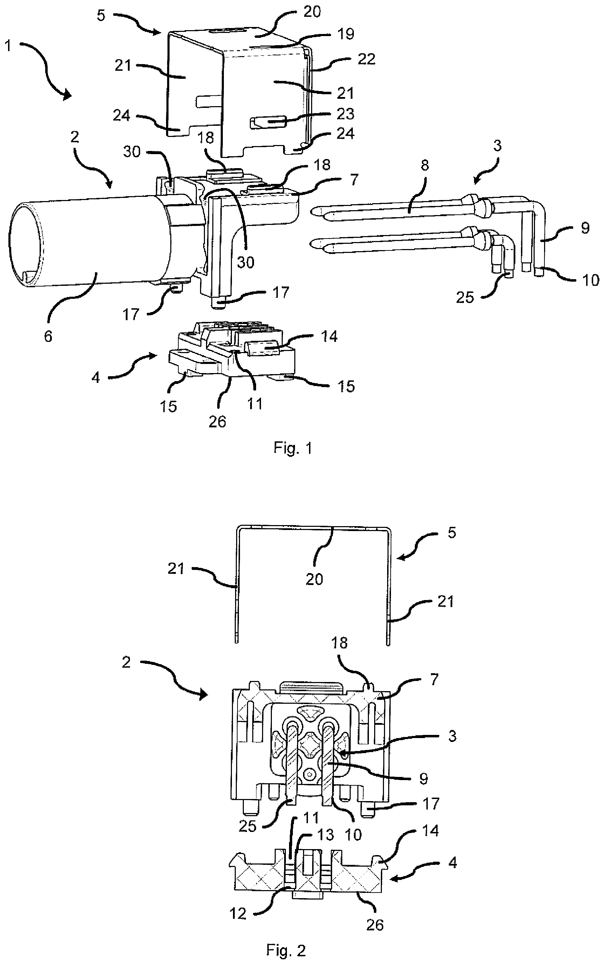

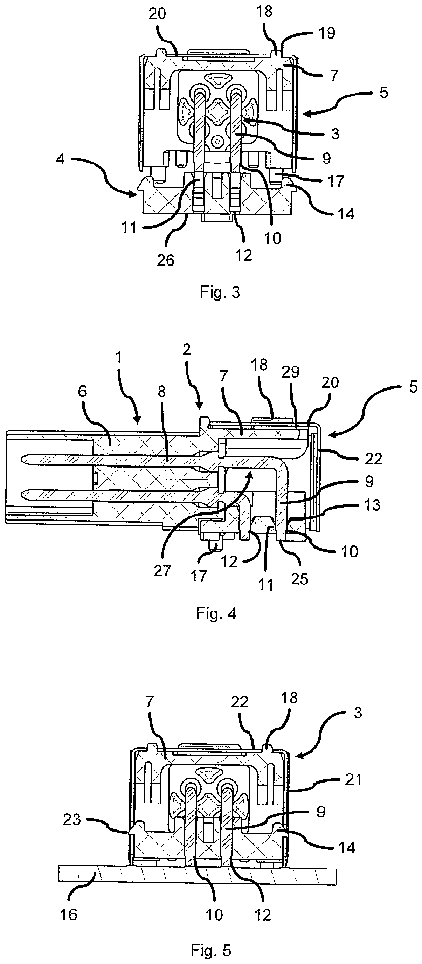

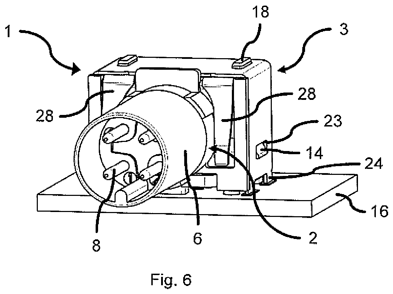

Figur 1 zeigt den Steckverbinder 1 mit einem Isolierkörper 2, Kontakten 3, Kontaktträger 4 und einem Gehäuse 5 vor dem Zusammenfügen. Der Kontaktträger 4 weist ein vorderes Isolierkörperteil 6 und ein hinteres Isolierkörperteil 7 auf, wobei der vordere rohrförmige Isolierkörperteil 6 die ersten Schenkel 8 der rechtwinkligen Kontrakte 3 voneinander isoliert in axialer Richtung aufnimmt. Die stiftförmigen um 90° abgewinkelten Kontakte 3 weisen den im eingebauten Zustand in horizontaler Richtung angeordneten ersten Schenkel 8 und den senkrecht dazu angeordneten zweiten Schenkel 9 auf, über den die Kontakt 3 zu einer Leiterplatte 16 (Figuren 5, 6) hergestellt wird. Der zweite Schenkel weist an seinem freien Ende einen als Anschlag dienen Ringbund 10 auf, derart, dass der Durchmesser des zweiten Schenkels 9 am freien Ende nach dem Ringbund 10 geringer ist als im restlichen Bereich des zweiten Schenkels 9. Der hintere Isolierkörperteil 7 dient der Fixierung des Steckverbinders 1 auf der Leiterplatte 16 derart, dass er einerseits Arretierzapfen 17 zum Einstecken in entsprechende Öffnungen in der Leiterplatte 16 aufweist und andererseits in Form von Erhebungen Ausrichtmittel 18 aufweist, die in Eingriff mit entsprechenden Öffnungen 19 im Deckel 20 des Gehäuses 5 in Eingriff gelangen, um Isolierkörper 2 und Gehäuse 2 zu stabilisieren. Das Gehäuse 5 kann grundsätzlich nur als U-förmiges Gehäuse mit zwei Seitenwänden 21 ausgebildet sein. In dem Ausführungsbeispiel dient das Gehäuse als Schirmung und ist daher metallisch ausgebildet und zusätzlich mit einer metallischen Rückwand 22 versehen. Durch die metallische Ausbildung des Gehäuses 5 kann dieses gewichtsmäßig so ausgestaltet werden, dass es für eine stabile Lage des gesamten Steckverbinders 1 auf der Leiterplatte 16 für die Montage sorgt, da andernfalls das vordere Isolierkörperteil 6 den Steckverbinder 1 kippen lassen würde. Das Gehäuse 5 weist außerdem an den Seitenwänden 21 Rastöffnungen 23 für den Eingriff der Rastnasen 14 des Kontaktträgers 4 auf. An den Seitenwänden sind noch Füße 24 angeformt, mit denen eine Lötverbindung auf der Leiterplatte 16 (Figur 6) hergestellt werden kann.

Das in der Figur 1 dargestellte Gehäuse 5 weist keine Frontseite auf, da diese in diesem Ausführungsbeispiel durch an das hintere Isolierkörperteil 7 von oben an der mit der Bezugsziffer 30 gekennzeichneten Stelle anklemmbare Kontaktfedern 28 (Figur 6) in Verbindung mit einem auf die Oberseite des hinteren Isolierkörperteils 7 einlegbaren Einlageblech 29 (Figur 4) gebildet wird. Die Kontaktfedern 28 werden somit über das Einlageblech 29 mit dem Gehäuse 5 elektrisch verbunden, so dass ein metallisches Schirmgehäuse entsteht, wobei die Kontaktfedern eine der Rückwand 22 gegenüberliegende Stirnwand bilden. Über die Kontaktfedern 28 kann dann das metallische Steckergehäuse eines nicht dargestellten Gegensteckverbinders, der bis zum Gehäuse 5 und den Kontaktfedern 28 über den vorderen Isolierkörperteil 6 geschoben wird, kontaktiert werden, so dass die Verbindung mit einem Schirmgeflecht des über den Gegensteckverbinder anschließbaren Kabels gewährleistet ist.

In Figur 2 sind in der Schnittdarstellung des Kontaktträgers 4 die Durchgangsöffnungen 11 ersichtlich, die im Einführungsbereich für den zweiten Schenkel 9 zur besseren Einführung konisch ausgebildet sind. In der Nähe der der Leiterplatte 16 zugewandten Unterseite 26 des Kontaktträgers 4 weisen die Durchgangsöffnungen 11 eine Durchgangsverjüngung in Form eines einen Anschlag bildenden Absatzes 12 auf, der bei der Montage die axiale Bewegung des Kontaktträgers 4 in das Gehäuse 5 durch den Anschlag an den Ringbund 10 am zweiten Schenkel 9 der Kontakte begrenzt. Die Bewegung des Kontaktträgers 4 bei der Montage ist in Figur 3 dargestellt, in der das Gehäuse 5 bereits auf dem Isolierkörper 2 aufgesteckt ist und die Kontakte 3 mit ihrem zweiten Schenkel 9 vor der Durchgangsöffnung 11 im Kontaktträger 4 sich befinden.

In den Figuren 4 und 5 ist der Kontaktträger 4 fest im Gehäuse 5 mit den Rastnasen 14 in den Rastnasen 23 verankert und die der Leiterplatte zugewandten Enden 25 der zweiten Schenkel 9 ragen für den Kontakt mit in der Leiterplatte 16 entsprechend angeordneten Anschlüssen aus dem Kontaktträger 4 mit einer definierten und einer geringen Toleranz aufweisenden Länge hervor. Die Figuren 4 und 5 zeigen den fertigen Steckverbinder 1 im Schnitt mit in dem Isolierkörper 2 angeordneten Kontakten 3 sowie die Anordnung des metallischen als Schirmung wirkenden Gehäuses 5 und dem darin fixierten Kontaktträger 4. Durch die Bewegung des Kontaktträgers 4 in axialer Richtung der zweiten Schenkel 9 der Kontakte 3 können Fertigungstoleranzen der einzelnen Kontakte durch ein nach oben Biegen der im Wesentlichen horizontal verlaufenden ersten Schenkel 8 im Bereich 27 des Gehäuses 5 ausgeglichen werden. Die Anschläge 12 in dem aus einem isolierenden Material, beispielsweise Kunststoff, hergestellten Kontaktträger 4 liegen in einer Ebene, sodass sichergestellt ist, dass alle Kontakte mit ihren freien Enden mit der gegeben Fertigungstoleranz auf einer Ebene auf der Leiterplatte 16 liegen. Durch die Füße 15 des Kontaktträgers 4 liegt dieser idealerweise auf der Leiterplatte 16 zusammen mit den Füßen 24 des Gehäuses 5 auf, wobei Fertigungstoleranzen in axialer Richtung der zweiten Schenkel durch die Ausgestaltung der Rastnasen 14 und deren Eingriff in die Rastöffnungen 23 im Gehäuse 5 ggf. der Kontaktträger 4 sich noch relativ zu dem Gehäuse 5 nach oben bewegen kann.

## Patentansprüche

1. Steckverbinder (1) zur Herstellung einer externen Verbindung mit einer Leiterplatte (16), der zumindest zwei gewinkelte stiftförmige Kontakte (3) mit einem ersten Schenkel (8) zur Kontaktierung eines Gegensteckverbinders und einem zweiten Schenkel (9) zur Kontaktierung der Leiterplatte (16), einen Isolierkörper (2) zur Aufnahme der Kontakte (3) zumindest im Bereich des ersten Schenkels (8) und einen Kontaktträger (4) zur Aufnahme der Kontakte (3) an ihrem zweiten Schenkel (9) aufweist, wobei die Kontakte (3) in einem Bereich am Ende des zweiten Schenkels (9) einen in axialer Richtung des zweiten Schenkels (9) wirkenden Anschlag (10) aufweisen, der Kontaktträger (4) in dem Bereich des zweiten Schenkels (9) angeordnet ist und für die zweiten Schenkel (9) Durchgangsöffnungen (11) mit einem Gegenanschlag (12) aufweist und in axialer Richtung der zweiten Schenkel (9) in ein den Kontaktträger (4) aufnehmendes Gehäuse (5) des Steckverbinders (1) bewegbar und darin fixierbar ist, **dadurch gekennzeichnet, dass** der Anschlag (10) zumindest an dem zweiten Schenkel (9) und der Gegenanschlag (12) in den Durchgangsöffnungen (11) durch einen Ringbund beim Übergang von einem größeren Durchmesser auf einen kleineren Durchmesser bei dem zweiten Schenkel (9) und den Durchgangsöffnungen (11) gebildet wird.

2. Steckverbinder (1) nach Anspruch 1, **dadurch gekennzeichnet, dass** zumindest die Ringbunde in den Durchgangsöffnungen (11) in einer Ebene liegen.

3. Steckverbinder (1) nach Anspruch 1 oder 2, **dadurch gekennzeichnet, dass** die Durchgangsöffnungen (11) auf der dem ersten Schenkel (8) zugewandten Seite des Kontaktträgers (4) konisch ausgebildet sind.

4. Steckverbinder (1) nach einem oder mehreren der vorangegangenen Ansprüche, **dadurch gekennzeichnet, dass** das Gehäuse (5) den Isolierkörper (2) mit dem darin angeordneten Kontakt (3) in einem hinteren Isolierkörperteil (7) zumindest teilweise und den Kontaktträger (4) übergreift.

5. Steckverbinder (1) nach einem oder mehreren der vorangegangenen Ansprüche, **dadurch gekennzeichnet, dass** der Kontaktträger (4) in dem Gehäuse (5) verrastbar ist.

6. Steckverbinder nach einem oder mehreren der vorangegangenen Ansprüche, **dadurch gekennzeichnet, dass** der Isolierkörper (2) mindestens einen Ausrichtfortsatz (17) zum Einstecken in eine Bohrung auf der Leiterplatte (16) und Ausrichtmittel (18) zur horizontalen Ausrichtung des Gehäuses (5) aufweist.

7. Steckverbinder nach einem oder mehreren der vorangegangenen Ansprüche, **dadurch gekennzeichnet, dass** das Gehäuse (5) U-förmig mit einem zwei Seitenwände (21) verbindenden Deckel (20) ausgebildet ist.

8. Steckverbinder nach Anspruch 7, **dadurch gekennzeichnet, dass** das Gehäuse (5) als Schirmblech mit einer Rückwand (22) und einer gegenüberliegenden Stirnwand ausgebildet ist, die den Isolierkörper (2) an einem vorderen Isolierkörperteil (6) über und seitlich umgreift.

9. Steckverbinder nach einem oder mehreren der vorangegangenen Ansprüche, **dadurch gekennzeichnet, dass** das Gehäuse (5) mit der Leiterplatte (16) verlötbar ausgebildet ist.

10. Steckverbinder nach einem oder mehreren der vorangegangenen Ansprüche, **dadurch gekennzeichnet, dass** das Gehäuse (5) metallisch und gewichtsmäßig so ausgeführt ist, dass der Schwerpunkt eine stabile Lage des gesamten Steckverbinders vor dem Löten sicherstellt.

## Claims

1. Plug connector (1) for producing an external connection with a printed circuit board (16), which plug connector has at least two angled pin-shaped contacts (3) with a first leg (8) for contacting a mating plug connector and a second leg (9) for contacting the printed circuit board (16), an insulating body (2) for receiving the contacts (3) at least in the region of the first leg (8), and a contact carrier (4) for receiving the contacts (3) at their second leg (9), wherein the contacts (3) have, in a region at the end of the second leg (9), a stop (10) which acts in the axial direction of the second leg (9), and the contact carrier (4) is arranged in the region of the second leg (9) and has through-openings (11) with a counter-stop (12) for the second legs (9) and can be moved in the axial direction of the second legs (9) into a housing (5) of the plug connector (1) that receives the contact carrier (4) and can be fixed therein, **characterized in that** the stop (10) at least on the second leg (9) and the counter-stop (12) in the through-openings (11) are formed by an annular collar at the transition from a larger diameter to a smaller diameter at the second leg (9) and the through-openings (11).

2. Plug connector (1) according to Claim 1, **characterized in that** at least the annular collars lie in one plane in the through-openings (11).

3. Plug connector (1) according to Claim 1 or 2, **characterized in that** the through-openings (11) have a conical design on the side of the contact carrier (4) that faces the first leg (8).

4. Plug connector (1) according to one or more of the preceding claims, **characterized in that** the housing (5) at least partially engages over the insulated body (2) with the contact (3) arranged therein in a rear insulting body part (7) and engages over the contact carrier (4).

5. Plug connector (1) according to one or more of the preceding claims, **characterized in that** the contact carrier (4) can be latched in the housing (5).

6. Plug connector according to one or more of the preceding claims, **characterized in that** the insulating body (2) has at least one orienting lug (17) for inserting into a hole in the printed circuit board (16) and orienting means (18) for horizontally orienting the housing (5).

7. Plug connector according to one or more of the preceding claims, **characterized in that** the housing (5) is of U-shaped design with a cover (20) connecting two lateral walls (21).

8. Plug connector according to Claim 7, **characterized in that** the housing (5) is designed as a shielding plate with a rear wall (22) and an opposite end wall which engages over and laterally around the insulating body (2) at a front insulating body part (6) .

9. Plug connector according to one or more of the preceding claims, **characterized in that** the housing (5) is designed such that it can be soldered to the printed circuit board (16).

10. Plug connector according to one or more of the preceding claims, **characterized in that** the housing (5) is metallic and configured in terms of weight in such a way that the centre of gravity ensures a stable position of the entire plug connector prior to soldering.

## Revendications

1. Connecteur enfichable (1) pour la réalisation d'une liaison externe avec une plaque conductrice (16) qui comporte au moins deux contacts en forme de tige (3) anguleux avec un premier côté (8) servant à mettre en contact un contre-connecteur enfichable et avec un deuxième côté (9) servant à mettre en contact la plaque conductrice (16) et qui comporte un corps isolant (2) servant à recevoir les contacts (3) au moins dans la zone du premier côté (8) et un support de contact (4) servant à recevoir les contacts (3) au niveau de son deuxième côté (9), les contacts (3) comportant dans leur zone située au niveau de l'extrémité du deuxième côté (9) une butée (10) agissant dans la direction axiale du deuxième côté (9), ledit support de contact (4) étant disposé dans la zone du deuxième côté (9) et comportant des ouvertures traversantes (11) pour le deuxième côté (9) avec une contre-butée (12) et le deuxième côté (9) pouvant être déplacé, dans la direction axiale, dans un carter (5) du connecteur enfichable (1) recevant le support de contact (4) et pouvant être fixé à l'intérieur, **caractérisé en ce que** la butée (10) est formée au moins au niveau du deuxième côté (9) et que la contre-butée (12) est formée dans les ouvertures traversantes (11) par une collerette annulaire lors de la transition d'un plus grand diamètre à un plus petit diamètre pour le deuxième côté (9) et les ouvertures traversantes (11).

2. Connecteur enfichable (1) selon la revendication 1, **caractérisé en ce qu'**au moins les collerettes annulaires disposées dans les ouvertures traversantes (11) reposent dans un plan.

3. Connecteur enfichable (1) selon la revendication 1 ou 2, **caractérisé en ce que** les ouvertures traversantes (11) sont réalisées de façon conique sur le côté du support de contact (4) orienté vers le premier côté (8).

4. Connecteur enfichable (1) selon l'une quelconque des revendications précédentes ou plusieurs d'entre elles, **caractérisé en ce que** le carter (5) agrippe au moins en partie le corps isolant (2) avec le contact (3) disposé à l'intérieur dans une partie de corps isolant arrière (7) ainsi que le support de contact (4).

5. Connecteur enfichable (1) selon l'une quelconque des revendications précédentes ou plusieurs d'entre elles, **caractérisé en ce que** le support de contact (4) peut être encastré dans le carter (5).

6. Connecteur enfichable selon l'une quelconque des revendications précédentes ou plusieurs d'entre elles, **caractérisé en ce que** le corps isolant (2) comporte au moins un prolongement aligné (17) à enficher dans un alésage placé sur la plaque conductrice (16) et des moyens d'alignement (18) par rapport à l'orientation horizontale du carter (5).

7. Connecteur enfichable selon l'une quelconque des revendications précédentes ou plusieurs d'entre elles, **caractérisé en ce que** le carter (5) est réalisé en forme de U avec un cache (20) reliant deux parois latérales (21) .

8. Connecteur enfichable selon la revendication 7, **caractérisé en ce que** le carter (5) est réalisé sous la forme d'une tôle-écran avec une paroi arrière (22) et une paroi avant opposée qui enserre par le dessus et en côté le corps isolant (2) au niveau d'une partie de corps isolant avant (6).

9. Connecteur enfichable selon l'une quelconque des revendications précédentes ou plusieurs d'entre elles, **caractérisé en ce que** le carter (5) est réalisé de façon à pouvoir être brasé avec la plaque conductrice (16).

10. Connecteur enfichable selon l'une quelconque des revendications précédentes ou plusieurs d'entre elles, **caractérisé en ce que** le carter (5) est réalisé sur le plan des métaux et du poids de façon à ce que le centre de gravité assure une position stable de l'ensemble du connecteur enfichable avant le brasage.
